# FASCICULE DE BREVET EUROPEEN

(11) **EP 2 896 075 B1**
(45) Date de publication et mention de la délivrance du brevet: **01.06.2016**
(21) Numéro de dépôt: 13774464.5
(22) Date de dépôt: 16.09.2013
(51) Int. Cl.: H01L 31/18

(54) **DISPOSITIF ET PROCEDE DE RESTAURATION DE CELLULES SOLAIRES PHOTO VOLTAIQUES A BASE DE SILICIUM**
VORRICHTUNG UND VERFAHREN ZUR WIEDERHERSTELLUNG VON FOTOVOLTAIKSOLARZELLEN AUF SILICIUMBASIS
DEVICE AND METHOD FOR RESTORING SILICON-BASED PHOTOVOLTAIC SOLAR CELLS

(30) Priorité: 14.09.2012 FR 1202454
(43) Date de publication de la demande: 22.07.2015
(73) Titulaire: Commissariat à l'Énergie Atomique et aux Énergies Alternatives, 75015 Paris (FR)
(72) Inventeur: DUBOIS, Sébastien, F-74950 Scionzier (FR); ENJALBERT, Nicolas, F-81100 Burlats (FR); GARANDET, Jean-Paul, 92210 Saint-Cloud (FR); GIDON, Pierre, F-38130 Echirolles (FR); TANAY, Florent, F-38000 Grenoble (FR); VEIRMAN, Jordi, F-74330 Poisy (FR)
(74) Mandataire: Talbot, Alexandre
(86) Numéro de dépôt international: PCT/FR2013/000240
(87) Numéro de publication internationale: WO 2014/041260

(56) Documents cités:
- WO-A1-2007/107351
- DE-A1-102009 059 300
- JP-A- 2003 332 598
- JI YOUN LEE: "Rapid Thermal Processing of Silicon Solar Cells-Passivation and Diffusion", DISSERTATION,, 1 janvier 2003 (2003-01-01), pages 35-64, XP002439621,

## Description

### Domaine technique de l'invention

L'invention est relative à un dispositif et un procédé destinés à supprimer les effets de dégradation du rendement sous éclairement des cellules solaires photovoltaïques à base de silicium.

### État de la technique

Les cellules solaires photovoltaïques réalisées à partir de substrats en silicium amorphe (a-Si), monocristallin (sc-Si) ou multicristallin (mc-Si), peuvent souffrir d'un effet de dégradation du rendement sous éclairement. Ce phénomène survient lors des premières utilisations des cellules solaires photovoltaïques, et il est usuellement appelé, effet « LID » (LID pour l'abréviation anglaise de « Light-Induced-Degradation »). Les mécanismes physiques à l'origine de cette dégradation du rendement des cellules solaires photovoltaïques sous éclairement, restent néanmoins mal connus. Par ailleurs, quelques études scientifiques ont montré que des éléments légers présents dans le silicium, notamment les atomes d'hydrogène (H), de bore (B) et d'oxygène (O) participent généralement à la formation et à l'activation de défauts lors de l'éclairement des cellules solaires photovoltaïques.

Les effets « LID » peuvent être supprimés en injectant des porteurs de charges dans les cellules solaires photovoltaïques tout en chauffant lesdites cellules. La demande internationale WO 2007/107351 divulgue un procédé visant une stabilisation du rendement des cellules solaires photovoltaïques lors de l'éclairement. Dans ce document, le procédé de restauration des cellules comporte une étape d'injection de porteurs de charge via un éclairement ou une polarisation en direct de la cellule solaire photovoltaïque, et une étape de chauffage du substrat à une température comprise entre 50 °C et 230 °C. Ce procédé de restauration a permis à la cellule solaire photovoltaïque traitée, de retrouver des performances stables sous des conditions normales de fonctionnement. Cependant, ce type de procédé de restauration nécessite un contrôle précis de la température. En effet, les effets de restauration ne prennent place que si la température des cellules solaires photovoltaïques ne dépasse pas une certaine température-limite qui est typiquement de l'ordre de 200 °C voire une température encore plus basse. En effet, les performances de certaines cellules solaires photovoltaïques à base de silicium peuvent être affectées lorsqu'elles sont maintenues à des températures supérieures à 150 °C.

En outre, le procédé décrit dans le document cité ci-dessus, nécessite des temps de traitement très élevés pour une restauration complète des cellules photovoltaïques. Par temps de traitement, on entend la durée au cours de laquelle les cellules solaires sont maintenues à une certaine température lors de la génération de porteurs de charge dans les cellules. Les temps de traitement peuvent atteindre une centaine d'heures, ce qui rend ce procédé incompatible avec les procédés industriels classiques de fabrication des cellules solaires photovoltaïques.

En effet, des traitements ont été réalisés, selon le procédé décrit dans ce document, pour restaurer des cellules solaires réalisées à partir de substrats en silicium purifiés par voie métallurgique. Pour ce type de cellules solaires, les mécanismes de restauration ont nécessité entre 10 et 40 heures pour des températures élevées comprises entre 150 et 180 °C.

Par ailleurs, la cinétique de restauration des cellules photovoltaïques peut être accélérée en augmentant la quantité de porteurs de charge injectée dans la cellule solaire photovoltaïque traitée. Cette augmentation peut être réalisée notamment en augmentant, la puissance de l'éclairement incident ou l'intensité du courant électrique injecté dans la cellule. Cependant, augmenter la puissance lumineuse incidente ou le courant électrique injecté, entraîne une élévation très importante de la température de la cellule solaire photovoltaïque, limitant ou supprimant les effets de restauration de la cellule solaire photovoltaïque.

La demande de modèle d'utilité CN201450015 décrit un dispositif permettant de chauffer et d'éclairer des cellules solaires à base de silicium pour les restaurer. Le dispositif comporte un système de ventilateurs pour refroidir les cellules photovoltaïques lors du traitement. Cependant, l'utilisation d'un système à base de ventilateurs ne permet pas l'obtention de cellules solaires de bonne qualité. Notamment, il a été observé que ce type de dispositif peut engendrer des problèmes de contraintes mécaniques, créant ainsi des microfissures dans les cellules solaires photovoltaïques.

### Objet de l'invention

Il existe un besoin de prévoir un dispositif efficace pour restaurer les cellules solaires photovoltaïques à base de silicium contre la dégradation du rendement lors de l'éclairement, tout en préservant l'intégrité mécanique et les performances photovoltaïques des cellules traitées.

On tend à satisfaire ce besoin en prévoyant un dispositif de restauration d'au moins une cellule solaire photovoltaïque à base de silicium, ledit dispositif comportant un support de la cellule solaire photovoltaïque, et des moyens de génération de porteurs de charge dans la cellule solaire photovoltaïque. En outre, le dispositif comporte une cuve destinée à être remplie par un liquide, et le support est configuré pour disposer la cellule solaire photovoltaïque dans le liquide.

On prévoit également un procédé de restauration d'au moins une cellule solaire photovoltaïque à base de silicium contre la dégradation du rendement sous éclairement par génération de porteurs de charge dans la cellule. Le procédé comporte une étape où la cellule solaire photovoltaïque est plongée dans un liquide lors de la génération de porteurs de charge dans la cellule solaire photovoltaïque, de manière à réguler la température de la cellule solaire photovoltaïque à une valeur de température ou dans une plage de température cible, comprise dans l'intervalle de température 50 °C - 230 °C.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figure 1 à 4 et 6 illustrent schématiquement, en coupe, des dispositifs selon différents modes de réalisation ;
- la figure 5 illustre schématiquement, une vue de dessus du dispositif de la figure 4.

### Description de modes préférentiels de réalisation

Le dispositif de guérison de cellules solaires photovoltaïques à base de silicium décrit ci-après diffère de l'art antérieur notamment en ce qu'il prévoit des éléments permettant de réguler la température des cellules solaires photovoltaïques lors de la mise en oeuvre du procédé de restauration afin d'augmenter la cinétique de restauration des cellules traitées.

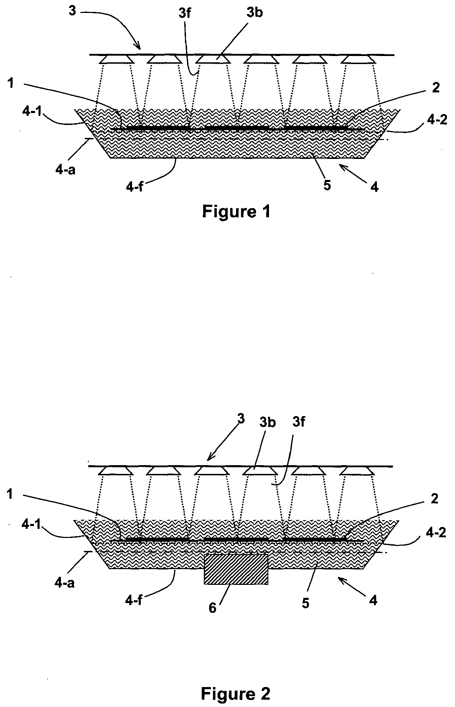

Selon un mode particulier de réalisation illustré à la figure 1, un dispositif de restauration de cellules photovoltaïques à base de silicium comporte un support 1 d'au moins une cellule solaire photovoltaïque 2. Le dispositif de restauration comporte également des moyens de génération 3 de porteurs de charge dans la cellule solaire photovoltaïque 2, et préférentiellement une source de chaleur (non représentée) configurée pour chauffer la cellule solaire photovoltaïque 2.

Les moyens de génération 3 de porteurs de charges peuvent, par exemple, comporter une source lumineuse éclairant la cellule solaire photovoltaïque 2 et/ou des moyens d'injection d'un courant électrique dans la cellule solaire photovoltaïque 2. Sur la figure 1, les moyens de génération 3 de porteurs de charge sont représentés comme étant une source lumineuse 3b, éclairant la cellule solaire photovoltaïque 2 par un faisceau lumineux 3f. Les moyens de génération 3 de porteurs de charge peuvent également constituer la source de chaleur du dispositif de restauration. À titre d'exemple, des lampes halogènes peuvent constituer à la fois les moyens de génération de porteurs de charge et la source de chaleur.

Le dispositif de restauration permet de chauffer la cellule solaire photovoltaïque 2 tout en y injectant des porteurs de charges, pour restaurer ladite cellule des effets de dégradation du rendement sous l'éclairement.

Afin d'augmenter l'efficacité de la restauration et accélérer sa cinétique, le dispositif comporte une cuve 4 destinée à être remplie par un liquide 5. En outre, le support 1 est configuré pour disposer la cellule solaire photovoltaïque 2 dans le liquide 5. Celle-ci est, en particulier, totalement immergée dans le liquide 5. La cuve 4 comporte un fond 4-f et des parois latérales. Dans un mode de réalisation particulier, les parois latérales comportent une première paroi latérale 4-1 disposée au niveau d'une première extrémité de la cuve 4, et une seconde paroi latérale 4-2 disposée au niveau d'une seconde extrémité opposée à la première extrémité selon un axe longitudinal 4-a de défilement des cellules solaires 2.

Le dispositif de restauration muni de la cuve 4 permet avantageusement une dissipation efficace et homogène de la température de la cellule solaire photovoltaïque 2 lors de l'injection de porteurs de charge, y compris lors d'une forte injection de porteurs de charge. Une forte injection de porteurs de charge, permet une accélération de la cinétique de restauration, et ainsi une réduction du temps de traitement des cellules photovoltaïques. Grâce au liquide 5 submergeant la cellule solaire photovoltaïque 2, l'élévation de la température, générée par la quantité de porteurs de charge injectée, est efficacement dissipée, ce qui permet d'obtenir une régulation de la température de la cellule solaire photovoltaïque, tout en évitant les problèmes de contraintes thermomécaniques. C'est ainsi que le dispositif de guérison permet la réalisation d'une restauration rapide et efficace des cellules photovoltaïques à base de silicium, tout en préservant l'intégrité mécanique desdites cellules.

Dans le mode de réalisation décrit ci-dessus, le dispositif de restauration comporte préférentiellement une source de chaleur configurée pour chauffer la cellule solaire photovoltaïque. Néanmoins, la source de chaleur peut être facultative : la cellule solaire photovoltaïque pourrait aussi bien être chauffée directement par le liquide 5.

Dans un mode de réalisation particulier illustré à la figure 2, la cuve 4 du dispositif de restauration comporte un régulateur 6 de la température du liquide 5. À titre d'exemple, le régulateur 6 peut comporter des dispositifs thermoélectriques ou des résistances électriques chauffantes, disposés dans les parois de la cuve 4, et commandés par un circuit de commande non représenté sur la figure 2.

Le régulateur 6 permet de contrôler avec précision la température du liquide 5 dans la cuve 4, et ainsi la température de la cellule solaire photovoltaïque 2. De ce fait, le régulateur 6 permet de réguler la température de la cellule solaire photovoltaïque 2 à une valeur ou une plage de température cible, lors de l'injection de porteurs de charge. Avantageusement, le régulateur 6 de la température du liquide 5 est configuré pour réguler la température de la cellule solaire photovoltaïque 2 à une valeur de température particulière (par exemple à 170°C) ou dans une plage de température particulière (par exemple entre 120°C et 190°C). Que la régulation concerne une valeur donnée de température ou une plage de température, la valeur ou la plage de température cible reste néanmoins toujours comprise dans l'intervalle de température 50 °C - 230 °C. En effet, pour des cellules photovoltaïques à base de silicium, les effets de restauration ne peuvent être réalisés que si la température de la cellule est comprise dans cette gamme de températures. La gamme de températures 50 °C - 230 °C permet ainsi d'obtenir une restauration rapide et efficace des cellules photovoltaïques 2, des effets de dégradation du rendement sous éclairement, tout en préservant les performances photovoltaïques des cellules traitées.

Par ailleurs, des thermocouples peuvent être mis en place sur toute la longueur du dispositif afin de contrôler avec précision la température du liquide 5 et/ou des cellules solaires photovoltaïques 2.

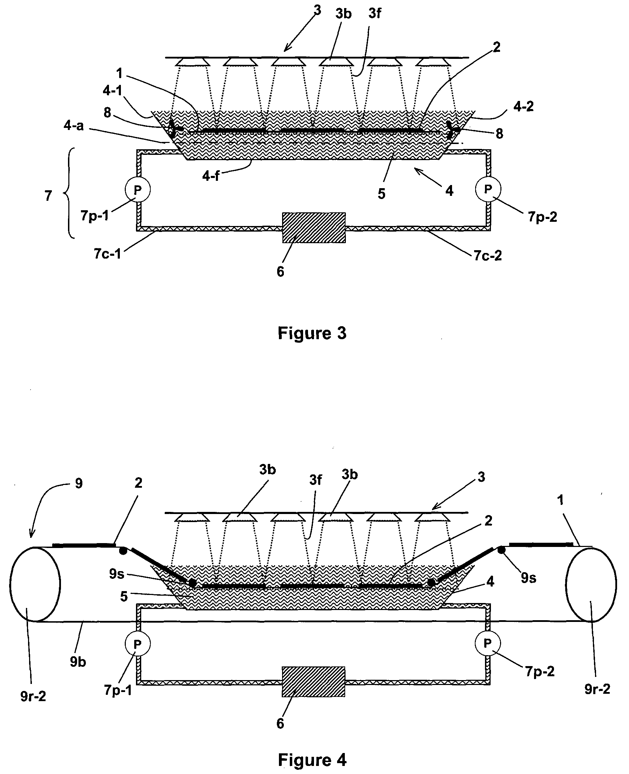

Dans un mode de réalisation particulier illustré à la figure 3, la cuve 4 comporte un dispositif de mise en circulation 7 du liquide 5 dans la cuve 4. Préférentiellement, les moyens de mise en circulation 7 du liquide 5 comporte des premier 7c-1 et deuxième 7c-2 conduits reliés l'un à l'autre, à l'une de leur extrémité. Le premier conduit 7c-1 peut être connecté à la cuve 4 via un orifice formé dans la première paroi latérale 4-1. Le second conduit est connecté à la cuve 4 via un orifice formé, de manière préférentielle, dans la deuxième paroi latérale 4-2. Afin de faire circuler le liquide 5 dans la cuve 4, le premier conduit 7c-1 peut comporter, par exemple, une première pompe 7p-1 configurée pour aspirer le liquide 5 de la cuve 4 vers le deuxième conduit 7c-2, qui comporte une deuxième pompe 7p-2. La deuxième pompe 7p-2 est configurée pour injecter le liquide 5 dans la cuve 4. Cette configuration des premiers 7c-1 et deuxième 7c-2 conduits permet une circulation du liquide 5 dans la cuve 4 suivant l'axe longitudinal 4-a.

Une circulation du liquide 5 dans la cuve 4 permet avantageusement, une meilleure homogénéisation de la température du liquide 5 dans la cuve 4, ce qui permet une meilleure dissipation de la chaleur de la cellule solaire photovoltaïque 2 vers le liquide 5. De manière avantageuse, les moyens de circulation 7 sont connectés au régulateur de la température 6 du liquide 5. Suivant ce mode de réalisation, le régulateur de la température 6 est configuré de manière à contrôler la température du liquide 5 injecté dans la cuve 4 via le deuxième conduit 7c-2. Préférentiellement, le circuit de commande du régulateur de la température 6 contrôle également les première 7p-1 et deuxième 7p-2 pompes. Avantageusement, le circuit de commande est configuré pour définir la température de la cellule solaire photovoltaïque 2 ou une plage de température autorisées pour la cellule solaire.

De manière avantageuse, la cuve 4 peut comporter un circuit de brassage mécanique 8 du liquide 5 dans la cuve 4. Préférentiellement, ce circuit de brassage 8 est associé aux moyens de circulation du liquide 5 dans la cuve 4. Les moyens mécaniques 8 peuvent comporter au moins une hélice disposée dans la cuve 4, par exemple sur l'une des parois latérales. Par ailleurs, la cuve 4 peut également comporter un transducteur ultrason. Préférentiellement, le transducteur ultrason est disposé dans la cuve de manière à être le plus proche possible de la cellule solaire photovoltaïque 2 à traiter. Pour ne pas perturber la propagation des ondes ultra-sonores vers la cellule solaire photovoltaïque 2, le transducteur est préférentiellement disposé de manière à éviter tout obstacle solide, tel que le support 1, entre le transducteur ultrason et ladite cellule. Le transducteur ultrason permet avantageusement une génération d'un mouvement de convection dans le liquide 5, conduisant ainsi à un brassage du liquide et une homogénéisation de sa température. En outre, le transducteur génère des ondes ultra-sonores qui peuvent favoriser les effets de diffusion, de réorientation et dissociation des défauts et complexes d'impuretés, accélérant ainsi davantage la cinétique de restauration.

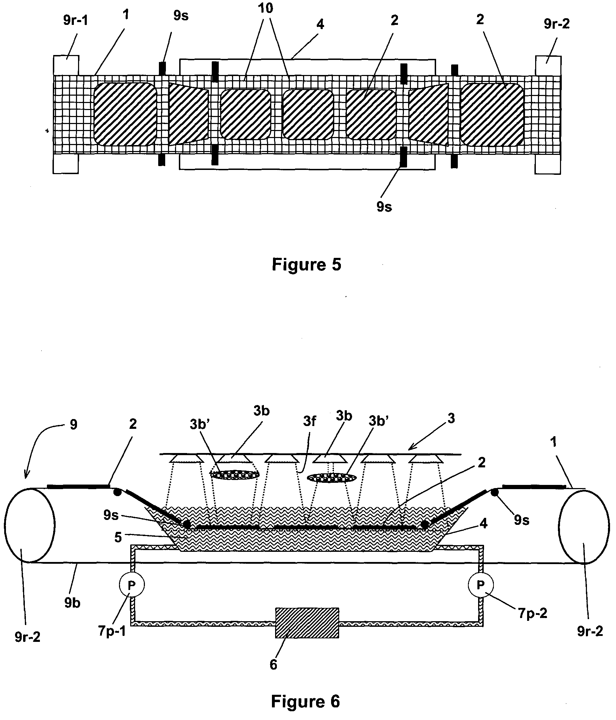

Selon un mode de réalisation illustré aux figures 4 et 5, le dispositif de restauration comporte des moyens de déplacement 9 du support 1 dans la cuve 4. Les moyens de déplacement 9 sont configurés pour faire déplacer la cellule solaire photovoltaïque 2 suivant une direction parallèle à la surface du liquide 5 dans la cuve 4. Le support 1 est conformé de manière à assurer un maintien stable des cellules solaires photovoltaïques 2 sur sa surface. Les moyens de déplacement 9 du support 1 peuvent être de type tapis roulant. De préférence, les moyens de déplacement 9 peuvent comporter des premier 9r-1 et deuxième 9r-2 rouleaux principaux, autour desquels le support 1 est enroulé pour former une boucle fermée 9b. En outre, les moyens de déplacement 9 comportent des rouleaux secondaires 9s configurés pour modifier l'axe de translation du support 1 lors de son déplacement suivant le chemin de la boucle fermée 9b. Comme illustré à la figure 5, les rouleaux secondaires 9s sont en contact uniquement avec les bords du support 1. Cette disposition permet d'éviter tout contact entre les rouleaux secondaires 9s et les cellules solaires photovoltaïques 2 lors du déplacement du support 1. Par ailleurs, au moins un des deux rouleaux principaux 9r-1 et 9r-2 est un rouleau moteur, configuré pour faire déplacer le support 1 en suivant le chemin de la boucle fermée 9b.

Cette configuration du dispositif de restauration permet ainsi une restauration accélérée de plusieurs cellules photovoltaïques disposées, par exemple les unes à la suite des autres ou bien côte à côte, sur le support 1 roulant. Le dispositif de restauration peut ainsi intégrer facilement une chaîne de production à grande échelle.

Avantageusement, le premier rouleau principal 9r-1 est un rouleau libre, et le deuxième rouleau principal 9r-2 est un rouleau moteur. De manière préférentielle, le rouleau moteur est configuré pour obtenir un sens de déplacement du support 1, opposé au sens de déplacement du liquide 5 dans la cuve 4. Ces déplacements opposés du support 1 et du liquide 5, permettent alors une meilleure dissipation de la chaleur depuis les cellules solaires photovoltaïques 2 vers le liquide 5 et favorisent le brassage du liquide 5.

Selon un mode de réalisation illustré à la figure 5, le support 1 comporte des trous traversants 10 de manière à ce que le liquide 5 soit en contact avec la face de la cellule solaire photovoltaïque 2 disposée sur le support 1. Cette configuration du support 1 permet d'augmenter la surface de contact entre les cellules solaires photovoltaïques 2 et le liquide 5, lorsque celles-ci sont noyées dans la cuve 4. Dès lors, l'augmentation de la surface de contact entre le liquide 5 et les cellules solaires photovoltaïques permet avantageusement d'assurer de meilleurs échanges thermiques entre les cellules 2 et le liquide 5. Par ailleurs, il est également avantageux que le support 1 soit à base d'un matériau ayant une conductivité thermique λₛ supérieure à la conductivité thermique de la cellule solaire photovoltaïque λ_{c}. De préférence, le support 1 est constitué de mailles souples en acier inoxydable.

Avantageusement, le dispositif de restauration comporte un circuit de commande général (non illustré aux figures) configuré pour commander :
- le régulateur de la température 6 du liquide 5 dans la cuve 4 ;
- les moyens de génération 3 de porteurs de charges injectée dans la cellule solaire photovoltaïque 2.

Le circuit de commande général est configuré pour réguler la température de la cellule solaire photovoltaïque 2 à une valeur ou dans une plage de température stable, comprise dans l'intervalle de température 50 °C - 230 °C, et avantageusement 120 °C - 210 °C. Préférentiellement le circuit de commande général contrôle également la vitesse de déplacement du support 1 dans la cuve 4, et les moyens de brassage.

Comme illustré aux figures 1 à 4, les moyens de génération de porteurs de charges 3 comportent une source lumineuse 3b destinée à éclairer la cellule solaire photovoltaïque 2. La source lumineuse 3b peut comporter des lampes monochromatiques permettant de produire un faisceau lumineux incident ayant une longueur d'onde comprise entre 300 et 1300 nm. La source lumineuse 3b peut aussi bien comporter des lampes halogènes ou xénon permettant de produire une lumière blanche. Préférentiellement, la source lumineuse 3b est configurée pour fournir un éclairement intense de manière à ce que les cellules photovoltaïques reçoivent un éclairement supérieur à 0,05 W.cm⁻². Par ailleurs, la source lumineuse 3b peut comporter une source laser, qui génère avantageusement un éclairement intense. L'utilisation d'une source laser permet avantageusement une réduction de la consommation énergétique, en comparaison avec les autres sources lumineuses.

Selon un mode particulier de réalisation illustré à la figure 6, la source lumineuse 3b comporte un système optique 3b' disposé entre les cellules solaires photovoltaïques et la source lumineuse 3b. À titre d'exemple, lorsque la source lumineuse 3b est une source laser, il est avantageux d'utiliser une lentille divergente comme système optique 3b'. Une lentille divergente permet ainsi d'augmenter la surface de la cellule solaire photovoltaïque recevant l'éclairement. Par ailleurs, lorsque la source lumineuse est constituée par une lampe halogène ou une lampe monochromatique, il est avantageux d'utiliser une lentille convergente comme système optique pour concentrer le faisceau lumineux et augmenter l'intensité de l'éclairement reçu par la cellule solaire photovoltaïque 2.

Selon un mode de réalisation, non illustré aux figures, les moyens de génération de porteurs de charge 3 peuvent comporter des moyens d'injection d'un courant électrique dans la cellule solaire photovoltaïque 2. À titre d'exemple, le dispositif de restauration comporte des pointes, reliées à une source de différence de potentiel. Lesdites pointes sont configurées pour entrer en contact avec la cellule solaire photovoltaïque 2 pour y injecter un courant électrique. Les moyens d'injection d'un courant électrique peuvent comporter des moyens de déplacement des pointes, configurés pour que les pointes et le support 1 aient le même mouvement. Ainsi, les pointes peuvent être considérées comme des éléments fixes par rapport à la cellule solaire photovoltaïque 2 en déplacement.

Les procédés classiques de restauration des cellules solaires photovoltaïques sont réalisés en chauffant les cellules dans un four classique (conventionnel ou à plaque chauffante), tout en générant une quantité de porteurs de charge dans les cellules. De tels équipements ne permettent cependant pas d'obtenir une dissipation suffisamment efficace de la chaleur apportée par la génération des porteurs de charge. En effet l'éclairement intense des cellules, indispensable à une restauration rapide des cellules, entraîne inévitablement une hausse très importante de la température des cellules solaires photovoltaïques, qui est dans les procédés classiques très difficile à contrôler et à réguler à la température souhaitée.

Selon un mode particulier de mise en oeuvre d'un procédé de restauration d'au moins une cellule solaire photovoltaïque à base de silicium contre les effets de dégradation du rendement sous éclairement, les contraintes sur l'étape de génération des porteurs de charge dans les cellules sont relâchées.

Préférentiellement, le procédé utilise un des dispositifs de restauration décrits ci-dessus, et illustrés aux figures 1 à 6. Le procédé de restauration comporte une étape où l'on prévoit au moins une cellule solaire photovoltaïque 2 réalisée dans un substrat ou dans une couche active, à base de silicium (amorphe, monocristallin ou multicristallin). Le procédé de restauration est réalisé en plongeant la cellule solaire photovoltaïque 2 dans un liquide 5 lors de la génération de porteurs de charge dans ladite cellule 2, de manière à réguler la température de la cellule solaire photovoltaïque 2 à une valeur ou une plage de température cible, comprise dans l'intervalle de température 50 °C - 230 °C et avantageusement 120 °C - 210 °C. Le chauffage de la cellule solaire photovoltaïque 2 peut être réalisé par une source de chaleur ou par les moyens de génération 3 de porteurs de charge, par exemple par des lampes halogènes. Préférentiellement, pour réaliser le procédé, on utilise le dispositif de restauration comportant le régulateur de la température 6 du liquide 5.

En fait, suivant le type des moyens de génération 3, par éclairement ou par injection d'un courant électrique, le liquide 5 peut être soit transparent au faisceau lumineux émis, soit électriquement isolant. Préférentiellement, les porteurs de charge sont injectés dans la cellule solaire photovoltaïque 2 par des moyens de génération 3 comportant une source de lumière 3b, et le liquide 5 est transparent au faisceau lumineux 3f émis par ladite source 3b.

Le liquide 5 peut être choisi en fonction de ses propriétés physico-chimiques notamment, la capacité thermique volumique, la chaleur latente de vaporisation, la conductivité thermique, et la viscosité.

Avantageusement, le liquide 5 ne présente pas de problèmes de toxicité et n'affecte pas les performances des cellules solaires photovoltaïques à base de silicium. Par ailleurs, le critère de mouillabilité du liquide 5 sur la cellule solaire photovoltaïque 2 est également un critère susceptible d'être pris en compte. En effet, ce critère peut jouer un rôle pour assurer un transfert thermique efficace entre le liquide 5 et la cellule solaire photovoltaïque 2. Avantageusement, le liquide 5 a un angle de contact, avec la cellule 2, inférieur à 90° et préférentiellement de l'ordre de 45°. Pour réaliser le procédé de restauration, le liquide 5 utilisé pour la régulation de la température de la cellule solaire photovoltaïque est avantageusement choisi de manière à ne pas s'évaporer au cours du traitement de restauration. Ainsi, le choix du liquide utilisé est intimement lié aux critères cités ci-dessus, mais également à la gamme de température dans laquelle le procédé de restauration est réalisé. Comme décrit ci-dessus, le procédé de restauration est avantageusement réalisé à une valeur ou une plage de température cible, comprise dans l'intervalle de température 50 °C - 230 °C. De manière avantageuse, le liquide 5 a une température d'ébullition supérieure strictement à 100 °C et avantageusement supérieure ou égale à environ 230 °C.

À titre d'exemple, le liquide 5 peut être choisi parmi la famille des liquides caloporteurs. Ce type de liquide se distingue par sa facilité à réguler la température de son environnement. Avantageusement, le liquide 5 est de l'éthylène glycol ou du glycérol. L'éthylène glycol est un fluide caloporteur, non toxique et qui a une température d'ébullition de 198 °C. Par ailleurs, le glycérol est un liquide non toxique et qui a une température d'ébullition de 290 °C mais, il commence à se décomposer à partir d'une température de 171 °C.

En outre, le liquide 5 peut être une huile de coupe soluble, qui comporte notamment une huile minérale, un émulgateur et de l'eau. Les huiles de coupe ont des caractéristiques physiques intéressantes. En effet, les huiles de coupe sont généralement transparentes, et elles ont une viscosité proche de celle de l'eau. De plus, ce type de liquide possède un pouvoir refroidisseur intéressant, et il reste à l'état liquide pour des températures supérieures à 100 °C.

Le procédé de restauration permet avantageusement de relâcher la contrainte sur l'étape de génération des porteurs de charge, pour augmenter la cinétique de restauration des cellules photovoltaïques des effets de dégradation du rendement sous éclairement. Le procédé permet ainsi d'augmenter l'intensité de la génération des porteurs dans la cellule, tout en régulant sa température à une température convenable pour obtenir une guérison stable.

À titre d'exemple, un dispositif de restauration de cellule solaire photovoltaïque a été réalisé selon l'invention. Les moyens de génération de porteurs de charge sont constitués par des lampes halogènes permettant à la cellule solaire photovoltaïque de recevoir un éclairement d'une intensité de 3 W.cm⁻². En utilisant des dispositifs classiques de restauration, la température de la cellule solaire photovoltaïque ne peut pas être maintenue en dessous de 145 °C lorsque la cellule solaire photovoltaïque reçoit une intensité d'éclairement supérieure à quelques dixièmes de W.cm⁻².

Pour le procédé de restauration, l'éthylène glycol régulé en température a été utilisé pour réguler la température de la cellule traitée à une température sensiblement égale à 145 °C. Le procédé selon l'invention a permis de restaurer la cellule en utilisant un éclairement intense (3 W.cm⁻²), après seulement 4 minutes de traitement. À titre de comparaison, des procédés de restauration selon le procédé de l'art antérieur ont montré que les mécanismes de guérison ont pris place entre 10 et 40 heures de traitement. Ces essais ont été réalisés en chauffant les cellules à une température comprise entre 150 °C et 180 °C, et un éclairement de 0,1 W.cm⁻².

Par ailleurs, le dispositif et le procédé de restauration décrits ci-dessus peuvent s'appliquer à une ou plusieurs cellules solaires photovoltaïques, qui peuvent être mises en module ou non.

## Revendications

1. Dispositif de restauration d'au moins une cellule solaire photovoltaïque à base de silicium, ledit dispositif comportant :
- un support (1) de la cellule solaire photovoltaïque (2) ;
- des moyens de génération (3) de porteurs de charge dans la cellule
solaire photovoltaïque (2) ;
**caractérisé en ce qu'**il comporte une cuve (4) destinée à être remplie par un liquide (5), et **en ce que** le support (1) est configuré pour disposer la cellule solaire photovoltaïque (2) dans le liquide (5).

2. Dispositif selon la revendication 1, **caractérisé en ce que** la cuve (4) comporte un régulateur (6) de la température du liquide (5).

3. Dispositif selon la revendication 2, **caractérisé en ce que** le régulateur (6) de la température du liquide (5) est configuré pour réguler la température de la cellule solaire photovoltaïque (2) à une valeur ou une plage de température cible, comprise dans l'intervalle de température 50 °C - 230 °C.

4. Dispositif selon la revendication 3, **caractérisé en ce que** le régulateur (6) de la température du liquide (5) comporte des résistances électriques chauffantes et/ou des dispositifs thermoélectriques disposés dans les parois de la cuve (4).

5. Dispositif selon l'une quelconque des revendications 1 à 4, **caractérisé en ce que** la cuve (4) comporte des moyens de mise en circulation (7) du liquide (5) dans la cuve (4).

6. Dispositif selon l'une quelconque des revendications 1 à 5, **caractérisé en ce que** la cuve (4) comporte un circuit de brassage mécanique (8) du liquide (5) dans la cuve (4).

7. Dispositif selon l'une quelconque des revendications 1 à 6, **caractérisé en ce qu'**il comporte des moyens de déplacement (9) du support (1) dans la cuve (4) configurés pour déplacer la cellule solaire photovoltaïque (2) suivant une direction (4-a) parallèle à la surface du liquide (6) dans la cuve (4).

8. Dispositif selon l'une quelconque des revendications 1 à 7, **caractérisé en ce que** le support (1) comporte des trous traversants (10) de manière à ce que le liquide (6) soit en contact avec la face de la cellule solaire photovoltaïque (2) disposée sur le support (1).

9. Dispositif selon l'une quelconque des revendications 1 à 8, **caractérisé en ce que** le support (1) est à base d'un matériau ayant une conductivité thermique (λₛ) supérieure à la conductivité thermique de la cellule solaire (λ_{c}) photovoltaïque (2).

10. Dispositif selon l'une quelconque des revendications 1 à 9, **caractérisé en ce que** les moyens de génération de porteurs de charge (3) comportent une source lumineuse (3b) destinée à éclairer la cellule solaire photovoltaïque (2).

11. Dispositif selon la revendication 10, **caractérisé en ce que** la source lumineuse (3b) comporte une source laser.

12. Dispositif selon l'une des revendications 10 et 11, **caractérisé en ce qu'**il comporte un système optique (3b') disposé entre la source lumineuse (3b) et la cellule solaire photovoltaïque (2).

13. Dispositif selon l'une quelconque des revendications 1 à 12, **caractérisé en ce que** les moyens de génération de porteurs de charge (3) comportent des moyens d'injection d'un courant électrique dans la cellule solaire photovoltaïque (2).

14. Procédé de restauration d'au moins une cellule solaire photovoltaïque (2) à base de silicium, contre la dégradation du rendement sous éclairement par génération de porteurs de charge dans ladite cellule (2), **caractérisé en ce que** la cellule solaire photovoltaïque (2) est plongée dans un liquide (5) lors de la génération de porteurs de charge dans ladite cellule (2), de manière à réguler la température de la cellule solaire photovoltaïque (2) à une valeur de température ou dans une plage de température cible, comprise dans l'intervalle de température 50 °C - 230 °C.

15. Procédé de restauration selon la revendication 14, **caractérisé en ce que** le liquide (5) a une température d'ébullition supérieure strictement à 100 °C.

16. Procédé de restauration selon la revendication 14, **caractérisé en ce que** le liquide (5) comporte de l'éthylène glycol ou du glycérol ou une huile de coupe soluble.

## Patentansprüche

1. Vorrichtung zur Wiederherstellung wenigstens einer photovoltaischen Solarzelle auf Siliciumbasis, wobei die Vorrichtung umfasst:
- einen Halter (1) der photovoltaischen Solarzelle (2);
- Mittel zur Erzeugung (3) von Ladungsträgern in der photovoltaischen Solarzelle (2);
**dadurch gekennzeichnet, dass** sie eine Wanne (4) umfasst, die dazu bestimmt ist, mit einer Flüssigkeit (5) gefüllt zu werden, und dass der Halter (1) dazu ausgelegt ist, die photovoltaische Solarzelle (2) in der Flüssigkeit (5) anzuordnen.

2. Vorrichtung nach Anspruch 1, **dadurch gekennzeichnet, dass** die Wanne (4) einen Regler (6) für die Temperatur der Flüssigkeit (5) umfasst.

3. Vorrichtung nach Anspruch 2, **dadurch gekennzeichnet, dass** der Regler (6) für die Temperatur der Flüssigkeit (5) dazu ausgelegt ist, die Temperatur der photovoltaischen Solarzelle (2) auf einen Zieltemperaturwert oder einen Zieltemperaturbereich, der innerhalb der Temperaturspanne von 50 °C bis 230 °C gelegen ist, zu regeln.

4. Vorrichtung nach Anspruch 3, **dadurch gekennzeichnet, dass** der Regler (6) für die Temperatur der Flüssigkeit (5) elektrische Heizwiderstände und/oder thermoelektrische Vorrichtungen, die in den Wänden der Wanne (4) angeordnet sind, umfasst.

5. Vorrichtung nach einem der Ansprüche 1 bis 4, **dadurch gekennzeichnet, dass** die Wanne (4) Mittel (7), um die Flüssigkeit (5) in der Wanne (4) in Zirkulation zu versetzen, umfasst.

6. Vorrichtung nach einem der Ansprüche 1 bis 5, **dadurch gekennzeichnet, dass** die Wanne (4) einen Kreis zum mechanischen Rühren (8) der Flüssigkeit (5) in der Wanne (4) umfasst.

7. Vorrichtung nach einem der Ansprüche 1 bis 6, **dadurch gekennzeichnet, dass** sie Mittel zum Bewegen (9) des Halters (1) in der Wanne (4) umfasst, die dazu ausgelegt sind, die photovoltaische Solarzelle (2) in einer Richtung (4-a) parallel zu der Oberfläche der Flüssigkeit (6) in der Wanne (4) zu bewegen.

8. Vorrichtung nach einem der Ansprüche 1 bis 7, **dadurch gekennzeichnet, dass** der Halter (1) Durchgangslöcher (10) umfasst, so dass die Flüssigkeit (6) mit der auf dem Halter (1) angeordneten Seite der photovoltaischen Solarzelle (2) in Kontakt ist.

9. Vorrichtung nach einem der Ansprüche 1 bis 8, **dadurch gekennzeichnet, dass** der Halter (1) auf der Basis eines Materials ist, das eine Wärmleitfähigkeit (λs), welche höher als die Wärmeleitfähigkeit (λc) der photovoltaischen Solarzelle (2) ist, aufweist.

10. Vorrichtung nach einem der Ansprüche 1 bis 9, **dadurch gekennzeichnet, dass** die Mittel zur Erzeugung von Ladungsträgern (3) eine Lichtquelle (3b) umfassen, die dazu bestimmt ist, die photovoltaische Solarzelle (2) zu beleuchten.

11. Vorrichtung nach Anspruch 10, **dadurch gekennzeichnet, dass** die Lichtquelle (3b) eine Laserquelle umfasst.

12. Vorrichtung nach einem der Ansprüche 10 und 11, **dadurch gekennzeichnet, dass** sie ein optisches System (3b') umfasst, das zwischen der Lichtquelle (3b) und der photovoltaischen Solarzelle (2) angeordnet ist.

13. Vorrichtung nach einem der Ansprüche 1 bis 12, **dadurch gekennzeichnet, dass** die Mittel zur Erzeugung von Ladungsträgern (3) Mittel zum Einspeisen eines elektrischen Stroms in die photovoltaische Solarzelle (2) umfassen.

14. Verfahren zur Wiederherstellung wenigstens einer photovoltaischen Solarzelle (2) auf Siliciumbasis, gegen die Degradation des Wirkungsgrades unter Bestrahlung, durch Erzeugen von Ladungsträgern in der Zelle (2), **dadurch gekennzeichnet, dass** die photovoltaische Solarzelle (2) bei der Erzeugung von Ladungsträgern in der Zelle (2) in eine Flüssigkeit (5) eingetaucht wird, um die Temperatur der photovoltaischen Solarzelle (2) auf einen Temperaturwert oder in einem Zieltemperaturbereich, der innerhalb der Temperaturspanne von 50 °C bis 230 °C gelegen ist, zu regeln.

15. Wiederherstellungsverfahren nach Anspruch 14, **dadurch gekennzeichnet, dass** die Flüssigkeit (5) eine Siedetemperatur, die streng oberhalb von 100 °C ist, aufweist.

16. Wiederherstellungsverfahren nach Anspruch 14, **dadurch gekennzeichnet, dass** die Flüssigkeit (5) Ethylenglykol oder Glycerin oder ein lösliches Schneidöl umfasst.

## Claims

1. A restoration device of at least one silicon-based photovoltaic solar cell, said device comprising:
- a support (1) of the photovoltaic solar cell (2);
- means (3) for generating charge carriers in the photovoltaic solar cell (2) ;
**characterized in that** it comprises a tank (4) designed to be filled by a liquid (5), and **in that** the support (1) is configured to arrange the photovoltaic solar cell (2) in the liquid (5).

2. The device according to claim 1, **characterized in that** the tank (4) comprises a regulator (6) of the temperature of the liquid (5).

3. The device according to claim 2, **characterized in that** the regulator (6) of the temperature of the liquid (5) is configured to regulate the temperature of the photovoltaic solar cell (2) to a target temperature value or range comprised within the 50 °C - 230 °C temperature range.

4. The device according to claim 3, **characterized in that** the regulator (6) of the temperature of the liquid (5) comprises electric resistance heaters and/or thermoelectric devices arranged in the walls of the tank (4).

5. The device according to any one of claims 1 to 4, **characterized in that** the tank (4) comprises circulation means (7) of the liquid (5) in the tank (4).

6. The device according to any one of claims 1 to 5, **characterized in that** the tank (4) comprises a mechanical stirring circuit (8) of the liquid (5) in the tank (4).

7. The device according to any one of claims 1 to 6, **characterized in that** it comprises movement means (9) of the support (1) in the tank (4) configured to move the photovoltaic solar cell (2) in a direction (4-a) parallel to the surface of the liquid (6) in the tank (4).

8. The device according to any one of claims 1 to 7, **characterized in that** the support (1) comprises pass-through holes (10) so that the liquid (6) is in contact with the surface of the photovoltaic solar cell (2) arranged on the support (1).

9. The device according to any one of claims 1 to 8, **characterized in that** the support (1) is made from a material having a higher thermal conductivity (λs) than the thermal conductivity (λ_{c}) of the photovoltaic solar cell (2).

10. The device according to any one of claims 1 to 9, **characterized in that** the charge carrier generating means (3) comprise a light source (3b) designed to illuminate the photovoltaic solar cell (2).

11. The device according to claim 10, **characterized in that** the light source (3b) comprises a laser source.

12. The device according to one of claims 10 and 11, **characterized in that** it comprises an optic system (3b') arranged between the light source (3b) and the photovoltaic solar cell (2).

13. The device according to any one of claims 1 to 12, **characterized in that** the charge carrier generating means (3) comprise means for injecting an electric current into the photovoltaic solar cell (2).

14. A restoration method of at least one silicon-based photovoltaic solar cell (2), to counteract degradation of the efficiency under illumination by generation of charge carriers in said cell (2), **characterized in that** the photovoltaic solar cell (2) is immersed in a liquid (5) when generation of charge carriers in said cell (2) takes place, so as to regulate the temperature of the photovoltaic solar cell (2) to a target temperature value or range comprised within the 50 °C - 230 °C temperature range.

15. The restoration method according to claim 14, **characterized in that** the liquid (5) has a boiling temperature higher than 100 °C.

16. The restoration method according to claim 14, **characterized in that** the liquid (5) comprises ethylene glycol or glycerol or a soluble cutting oil.
